# EUROPEAN PATENT SPECIFICATION

(11) **EP 4 279 927 B1**
(45) Date of publication and mention of the grant of the patent: **29.10.2025**
(21) Application number: 23733189.7
(22) Date of filing: 20.03.2023
(51) Int. Cl.: G01R 1/04, G01R 31/385, G01R 31/36, G01R 1/067

(54) **TEST CLIP AND TESTING ASSEMBLY**
TESTKLAMMER UND TESTVORRICHTUNG
PINCE DE TEST ET ENSEMBLE DE TEST

(30) Priority: 02.04.2022 CN 202220768974 U
(43) Date of publication of application: 22.11.2023
(73) Proprietor: Contemporary Amperex Technology (Hong Kong) Limited, Central, Central And Western District (HK)
(72) Inventor: ZHANG, Rongji, Ningde Fujian 352100 (CN); CAO, Bin, Ningde Fujian 352100 (CN)
(74) Representative: Ziebig Hengelhaupt Intellectual Property Attorneys Patentanwaltskanzlei PartGmbB
(86) International application number: PCT/CN2023/082574
(87) International publication number: WO 2023/185529

(56) References cited:
- CN-U- 203 396 819
- CN-U- 207 780 182
- CN-U- 209 979 813
- CN-U- 214 280 037
- CN-U- 215 070 687
- CN-U- 215 180 606
- CN-U- 215 180 737
- CN-U- 217 505 926
- CN-Y- 2 768 020
- JP-A- 2015 087 274
- JP-A- 2015 087 274
- KR-A- 20140 131 079
- KR-B1- 101 825 006
- US-A- 4 041 380
- US-A- 5 985 481
- US-B1- 10 938 130

## Description

### TECHNICAL FIELD

This application relates to the field of voltage testing technologies, and specifically to a test clip and a testing assembly.

### BACKGROUND

At present, testing devices for testing voltage or current of batteries are in the form of a crimp or a clamp. However, both forms of testing devices can be applied to only corresponding testing scenarios, limiting the testing ranges of the testing devices. US10938130B1 discloses a plug-in point adapter providing a self-contained adapter assembly that may be plugged into the connector jack of an existing electrical alligator clip probe and which increases the length of the probe. In some implementations, the adapter includes a test point that can be projected forward to a selectable length between the jaws of the clip that allows the clip to be used either as the point of a test probe or the original service as an alligator probe. In some implementations, the adapter transfers the alligator jack to the adapter jack for connection of the test lead plug. In some implementations, the adapter latches to the alligator clip and remains on permanently. The original alligator clip is not modified in any way and therefore the adapter can be customized for various designs of alligator clips that do not have to be modified.

### SUMMARY

Embodiments of this application provide a test clip and a testing assembly, so as to solve the problem of limited testing range of a testing device for testing voltage and/or current of a battery. The present invention is defined by the test clip of independent claim 1 and the testing assembly of claim 7. In the following, in case parts of the description and drawing referring to embodiments, which are not covered by the claims are not presented as embodiments of the invention, but as examples useful for understanding the invention.

According to a first aspect encompassed by the wording of the claims, an embodiment of this application provides a test clip including a clip body and a base, where the base is connected to the clip body, and the base is configured to be detachably connected to a crimp probe head to achieve an electrical connection between the crimp probe head and the clip body.

In the foregoing technical solution, the test clip is divided into the clip body and the base connected to each other. The base is configured to be detachably connected to the crimp probe head to achieve the electrical connection between the crimp probe head and the clip body, so that a piece under test can be clamped by the clip body for testing. This transforms a crimp-type testing device into a clamp-type testing device which can be used in a testing environment that requires clamping, thereby improving the convenience in testing.

In this first aspect, the base has a first inserting portion, where the first inserting portion is configured to fit with the crimp probe head in an insertion manner.

In the foregoing technical solution, the first inserting portion of the base is configured to fit with the crimp probe head in an insertion manner to achieve a detachable connection between the base and the crimp probe head. This simplifies the structure for achieving a detachable connection between the first inserting portion and the crimp probe head, making the connection simple and convenient.

In this first aspect, the first inserting portion is a jack.

In this first aspect, the first inserting portion is a jack, and the crimp probe head is inserted in the jack to achieve an insertion fit. This can reduce the weight of the test clip and facilitate the detachable connection between the crimp probe head and the base.

In some embodiments of the first aspect of this application, one of an inner wall of the jack and the crimp probe head is provided with a snap-fit portion, and the other is provided with a snap-fit groove. The snap-fit portion is configured to be snap fitted into the snap-fit groove after the crimp probe head is inserted into the jack.

In the foregoing technical solution, after the crimp probe head is inserted into the jack, the snap-fit portion is snap fitted into the snap-fit groove, which can implement axial limit for the base and the crimp probe head in an axial direction of the jack. This makes it more difficult for the crimp probe head to be separated from the base in the axial direction of the jack, thus reducing the risk of separation of the crimp probe head from the base in the axial direction of the jack during testing.

In this first aspect, the snap-fit groove is a ring groove or the snap-fit groove is a non-closed structure in a circumferential direction of the jack and in an axial direction of the jack, the snap-fit portion has a first guide slope and a second guide slope opposite each other, the first guide slope is configured to guide the snap-fit portion to be snap fitted into the snap-fit groove, and the second guide slope is configured to guide the snap-fit portion to be disengaged from the snap-fit groove.

In the foregoing technical solution, if the snap-fit groove is a ring groove, the snap-fit portion can be snap fitted into the snap-fit groove from any position in the circumferential direction of the snap-fit groove without alignment or positioning, thereby reducing the difficulty of snap-fit. If the snap-fit groove is a non-closed structure in a circumferential direction of the jack, the influence of provision of the snap-fit groove on the structural strength of the base or crimp probe head provided with the snap-fit grove can be reduced.

In some embodiments of the first aspect of this application, the crimp probe head includes a second inserting portion and a probe, where the second inserting portion is configured to fit with the jack in an insertion manner, the second inserting portion has an insertion end to be inserted into the jack, and the probe partially protrudes from the insertion end; and the jack has a bottom wall, where the bottom wall is used to abut against a part of the probe protruding from the insertion end after the second inserting portion is inserted into the jack, so as to achieve an electrical connection between the probe and the clip body.

In the foregoing technical solution, the jack has a bottom wall, meaning that the jack is a blind hole. The bottom wall of the jack is used to abut against the probe to facilitate the electrical connection between the crimp probe head and the test clip.

In some embodiments of the first aspect of this application, the base is cylindrical, and the base is coaxial with the jack.

In the foregoing technical solution, the base is cylindrical, so the outer circumference of the base is a cylindrical surface without ridges, which can reduce the risk of damage caused by bumping. The base is coaxial with the jack, which allows a more regular structure of the test clip, facilitating the detachable connection between the crimp probe head and test clip.

In some embodiments of the first aspect of this application, the clip body is connected to one end of the base, and the jack is provided at the other end of the base and recessed toward a direction approaching the clip body.

In the foregoing technical solution, the jack and the clip body are respectively provided at opposite ends of the base, facilitating installation of the crimp probe head and the clip body and reducing the risk of interference between the crimp probe head and the clip body.

In some embodiments of the first aspect of this application, the clip body includes a first clamping portion and a second clamping portion, where the first clamping portion is hinged to the second clamping portion, the first clamping portion and the second clamping portion are configured to cooperate to clamp the piece under test, and the base is connected to one end of the first clamping portion or one end of the second clamping portion.

In the foregoing technical solution, the base is connected to one end of the first clamping portion or one end of the second clamping portion, allowing the other clamping portion to rotate relative to the clamping portion connected to the base, so that the two clamping portions cooperate to clamp the piece under test.

According to a second aspect, an embodiment of this application provides a testing assembly including the test clip provided in the embodiments of the first aspect, a tester, and a crimp probe head. The crimp probe head is electrically connected to the tester. The crimp probe head is configured to be detachably connected to the base to achieve an electrical connection between the crimp probe head and the clip body.

In the foregoing technical solution, the testing assembly includes the crimp probe head and the test clip, and the crimp probe head is electrically connected to the tester, so that the testing assembly can directly test a piece under test using the crimp probe head. Alternatively, the base of the test clip may be detachably connected to the crimp probe head to achieve the electrical connection between the clip body and the crimp probe head, and then the test clip can clamp the piece under test for testing. In this way, the testing assembly can not only be used in testing environments that require a crimp-type probe head, but also be used in testing environments that require a clamp-type probe head, expanding the application range of the testing assembly.

### BRIEF DESCRIPTION OF DRAWINGS

To describe the technical solutions of the embodiments of this application more clearly, the following briefly describes the accompanying drawings required for describing the embodiments. It is appreciated that the accompanying drawings below show merely some embodiments of this application and thus should not be considered as limitations on the scope. Persons of ordinary skill in the art may still derive other related drawings from the accompanying drawings without creative efforts.
FIG. 1 is an axonometric view of a test clip according to some embodiments of this application;
FIG. 2 is a cross-sectional view of a test clip according to some embodiments of this application;
FIG. 3 is a schematic diagram of a structure of the test clip in FIG. 2 detachably connected to a crimp probe head;
FIG. 4 is a schematic diagram of a structure of a test clip detachably connected to a crimp probe head encompassed by the wording of the claims;
FIG. 5 is a cross-sectional view of a test clip according to some other embodiments not encompassed by the wordings of the claims;
FIG. 6 is a schematic diagram of the test clip in FIG. 5 detachably connected to a crimp probe head;
FIG. 7 is a schematic diagram of a relative position relationship between a base and a first inserting portion of a test clip according to some embodiments of this application;
FIG. 8 is a schematic diagram of a testing assembly with test clips and crimp probe heads detachably connected to each other according to some embodiments of this application; and
FIG. 9 is a schematic diagram of a testing assembly with test clips and crimp probe heads separated from each other according to some embodiments of this application.

Reference signs: 100. testing assembly; 10. test clip; 11. clip body; 111. first clamping portion; 1111. first corrugated surface; 1112. connecting portion; 112. second clamping portion; 1121. second corrugated surface; 12. base; 121. first inserting portion; 122. snap-fit groove; 20. crimp probe head; 21. second inserting portion; 211. insertion end; 22. snap-fit portion; 221. first guide slope; 222. second guide slope; 23. probe; 30. tester; and 40. wire.

### DESCRIPTION OF EMBODIMENTS

To make the objectives, technical solutions, and advantages of the embodiments of this application clearer, the following clearly and completely describes the technical solutions in the embodiments of this application with reference to the accompanying drawings in the embodiments of this application. Apparently, the described embodiments are some but not all embodiments of this application. Generally, the components of the embodiments of this application as described and illustrated in the accompanying drawings herein can be arranged and designed in a variety of configurations.

Therefore, the following detailed description of the embodiments of this application as provided in the accompanying drawings is not intended to limit the claimed scope of this application but merely to represent selected embodiments of this application. All other embodiments obtained by persons of ordinary skill in the art based on the embodiments of this application without creative efforts shall fall within the protection scope of this application.

It should be noted that, without conflict, the embodiments and features in the embodiments in this application may be combined with each other.

It should be noted that similar reference signs and letters indicate similar items in the following drawings, and therefore once an item is defined in one drawing, it does not need to be further defined or explained in the subsequent drawings.

In the description of the embodiments of this application, it should be noted that the orientations or positional relationships as indicated are orientations or positional relationships based on the accompanying drawings, or conventional orientations or positional relationships of products of this application, or orientations or positional relationships as conventionally understood by persons skilled in the art, and the orientations or positional relationships as indicated are merely for ease and brevity of description of this application rather than indicating or implying that the apparatuses or elements mentioned must have specific orientations or must be constructed or manipulated according to specific orientations, and therefore cannot be understood as limitations on this application. In addition, the terms "first", "second", "third", and the like are merely intended for distinguishing purposes and shall not be understood as any indication or implication of relative importance.

Currently, from a perspective of market development, application of traction batteries has become more extensive. Traction batteries have been not only used in energy storage power supply systems such as hydroelectric power plants, thermal power plants, wind power plants, and solar power plants, but also widely used in many other fields including electric transportation tools such as electric bicycles, electric motorcycles, and electric vehicles, military equipment, and aerospace. With continuous expansion of application fields of traction batteries, market demands for the traction batteries are also expanding.

A battery includes two electrode terminals and a body portion having an electrode assembly. The two electrode terminals are configured to output electrical energy from the battery. The two electrode terminals are a positive electrode terminal and a negative electrode terminal. The positive electrode terminal and the negative electrode terminal are electrically connected to a positive electrode tab and a negative electrode tab of the electrode assembly, respectively. In some embodiments, the electrode terminals are recessed relative to the body portion or flush with a surface of the body portion. In some other embodiments, the electrode terminals protrude from the body portion to form poles.

To detect whether the battery meets the usage requirements, a special testing device needs to be used for testing the voltage and/or current of the battery. The inventors have found that currently, there are mainly two types of testing devices: crimp-type testing devices and clamp-type testing devices. The clamp-type testing device may be used for testing voltage and/or current of a battery with electrode terminals protruding from the body portion. During testing, the electrode assembly is clamped using a clamping portion, without requiring testing personnel to keep the testing device in contact with the electrode terminals. However, such testing device is not suitable for detecting a battery with electrode terminals recessed relative to the body portion or flush with the body portion. The crimp-type testing device may be used for testing voltage and/or current of a battery having any form of electrode terminals. However, during testing, testing personnel need to keep the crimp-type testing device in contact with the electrode terminals, which increases the cost of testing personnel and brings inconvenience to testing. It can be seen that the crimp-type testing device and the clamp-type testing device have their own testing defects, resulting in inconvenience in testing and limitations on the testing ranges of the testing devices.

Based on the above considerations, to solve the problem of limited testing range of a testing device for testing voltage and/or current of a battery, the inventors have designed a test clip after intensive research. The test clip includes a clip body and a base connected to each other. The clip body is configured to clamp a piece under test. The base is configured to be detachably connected to a crimp probe head to achieve an electrical connection between the crimp probe head and the clip body. The test clip is divided into the clip body and the base connected to each other. The clip body is configured to clamp the piece under test, and the base is configured to be detachably connected to the crimp probe head to achieve the electrical connection between the crimp probe head and the clip body, so that the piece under test can be clamped by the clip body for testing. This transforms a crimp-type testing device into a clamp-type testing device which can be used in a testing environment that requires clamping, thereby improving the convenience in testing.

The test clip disclosed in the embodiments of this application can be used for but is not limited to voltage and/or current testing of batteries. The test clip is used for testing voltage and/or current of a power supply system that has an electric apparatus with a battery and the like. This helps solve the problem of limited testing range of the testing device for testing voltage and/or current and improves the convenience in testing. Certainly, depending on actual needs, the test clip disclosed in this application may also be used in other fields.

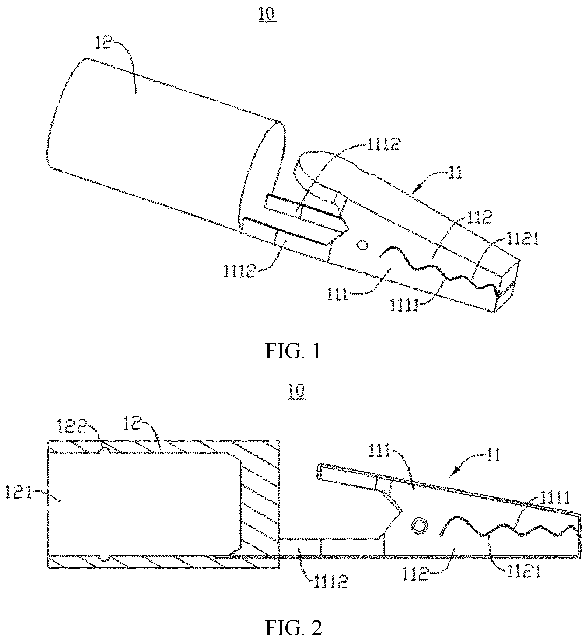

Referring to FIG. 1 and FIG. 2, FIG. 1 is an axonometric view of a test clip 10 according to some embodiments of this application; and FIG. 2 is a cross-sectional view of a test clip 10 according to some embodiments of this application. The test clip 10 includes a clip body 11 and a base 12. The base 12 is connected to the clip body 11. The base 12 is configured to be detachably connected to a crimp probe head 20 to achieve an electrical connection between the crimp probe head 20 and the clip body 11.

The clip body 11 is configured to clamp a piece under test. Depending on the application fields of the test clip 10, the pieces under test may be different objects. In the embodiments of this application, the structure and working principle of the test clip 10 is described by taking the example that the piece under test is a battery.

The clip body 11 of the test clip 10 is configured to clamp the piece under test. For example, if the piece under test is a battery, the clip body 11 is configured to clamp electrode terminals of the battery.

The base 12 is configured to be detachably connected to the crimp probe head 20. When the test clip 10 is needed for testing, the test clip 10 is detachably connected to the crimp probe head 20 via the base 12. When the crimp probe head 20 is needed for testing, the test clip 10 is separated from the crimp probe head 20.

The crimp probe head 20 may be used for testing voltage and/or current of a battery with electrode terminals of any form. However, during testing, it requires testing personnel to keep the crimp-type testing device in contact with the electrode terminals. Testing is performed by leaving a probe 23 of the crimp probe head 20 in contact with the electrode terminals of the battery. After the crimp probe head 20 is connected to the base 12 of the test clip 10, the crimp probe head 20 is electrically connected to the clip body 11, and then the piece under test can be clamped by the clip body 11 and be subjected to testing. In this case, testing personnel do not need to keep the piece under test in contact with the electrode terminals. In this embodiment, both the base 12 and the clip body 11 are conductors.

The test clip 10 is divided into the clip body 11 and the base 12 connected to each other. The clip body 11 is configured to clamp the piece under test, and the base 12 is configured to be detachably connected to the crimp probe head 20 to achieve the electrical connection between the crimp probe head 20 and the clip body 11. In this way, the piece under test can be clamped by the clip body 11 for testing. This transforms a crimp-type testing device into a clamp-type testing device which can be used in a testing environment that requires clamping, thereby improving the convenience in testing.

The base 12 and the crimp probe head 20 can be detachably connected in many ways. For example, the base 12 and the crimp probe head 20 are detachably connected by hooking, binding, or the like. For another example, in some embodiments, the base 12 has a first inserting portion 121. The first inserting portion 121 is configured to fit with the crimp probe head 20 in an insertion manner.

The crimp probe head 20 has a second inserting portion 21. One of the first inserting portion 121 and the second inserting portion 21 is a jack, and the other one of the first inserting portion 121 and the second inserting portion 21 is inserted into the jack, so as to achieve an insertion fit between the first inserting portion 121 and the crimp probe head 20.

The first inserting portion 121 of the base 12 is configured to fit with the crimp probe head 20 in an insertion manner, so as to achieve a detachable connection between the base 12 and the crimp probe head 20. This simplifies the structure for achieving a detachable connection between the first inserting portion 121 and the crimp probe head 20, making the connection simple and convenient.

As shown in FIG. 2, in some embodiments, the first inserting portion 121 is a jack.

The second inserting portion 21 of the crimp probe head 20 can be inserted into the jack in an axial direction of the jack to achieve the detachable connection between the base 12 and the crimp probe head 20. In some other embodiments, it may be that the second inserting portion 21 is a jack and the second inserting portion 21 of the base 12 is inserted into the jack.

If the first inserting portion 121 is a jack, the crimp probe head 20 is inserted in the jack to achieve an insertion fit, which can reduce the weight of the test clip 10 and facilitate the detachable connection between the crimp probe head 20 and base 12.

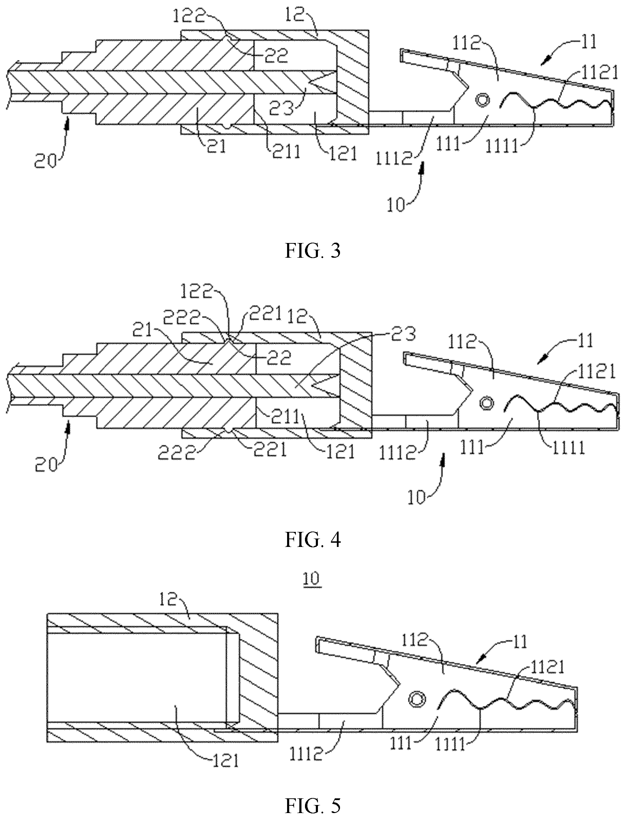

After the crimp probe head 20 is inserted into the jack in the axial direction of the jack to achieve the insertion connection between the crimp probe head 20 and the base 12, the crimp probe head 20 and the base 12 are also easily separated from each other in the axial direction of the jack. To improve the stability of the insertion fit between the crimp probe head 20 and the base 12, refer to FIG. 2 and FIG. 3. FIG. 3 is a schematic diagram of a structure of the test clip 10 detachably connected to the crimp probe head 20 according to some embodiments of this application. According to the claims, one of an inner wall of the jack and the crimp probe head 20 is provided with a snap-fit portion 22, and the other is provided with a snap-fit groove 122. The snap-fit portion 22 is configured to be snap fitted into the snap-fit groove 122 after the crimp probe head 20 is inserted into the jack.

As shown in FIG. 2 and FIG. 3, the jack is provided in the base 12, the snap-fit groove 122 is provided in the inner wall of the jack, and the snap-fit portion 22 is disposed on the crimp probe head 20. The snap-fit portion 22 is a resilient protrusion disposed on a surface of the second inserting portion 21 of the crimp probe head 20. In the process of the second inserting portion 21 being inserted into the jack, the inner wall of the jack presses the snap-fit portion 22, causing the snap-fit portion 22 to deform. When the snap-fit portion 22 and the snap-fit groove 122 are opposite each other in a radial direction of the jack, the inner wall of the jack is separated from the snap-fit portion 22, not pressing the snap-fit portion 22. The snap-fit portion 22 recovers from the deformation, so that the snap-fit portion 22 is snap fitted into the snap-fit groove 122.

In this embodiment not encompassed by the wording of the claims, the snap-fit portion 22 has a curved surface, allowing the snap-fit portion 22 to be snap fitted into the snap-fit groove 122 in the process of the second inserting portion 21 being inserted into the jack, and allowing disengagement of the snap-fit portion 22 from the snap-fit groove 122 in the process of the second inserting portion 21 receiving a force in an opposite direction of the insertion.

The snap-fit portion 22 is in other structural forms in embodiments encompassed by the wording of the claims. As shown in FIG. 4 which is a schematic diagram of a structure of the test clip 10 connected to the crimp probe head 20 according to embodiments encompassed by the wording of the claims, in the axial direction of the jack, the snap-fit portion 22 has a first guide slope 221 and a second guide slope 222 opposite each other. The first guide slope 221 is configured to guide the snap-fit portion 22 to be snap fitted into the snap-fit groove 122 in the process of the second inserting portion 21 being inserted into the jack, allowing the snap-fit portion 22 to be snap fitted into the snap-fit groove 122 more easily and reducing the risk of stress concentration at the joint between the snap-fit portion 22 and the second inserting portion 21. The second guide slope 222 is configured to guide the snap-fit portion 22 to be disengaged from the snap-fit groove 122 when the second inserting portion 21 receives a force in an opposite direction of the insertion, allowing easier disengagement of the snap-fit portion 22 to from the snap-fit groove 122 and reducing the difficulty in separating the crimp probe head 20 from the base 12.

In some other embodiments, the snap-fit groove 122 may alternatively be provided in the second inserting portion 21 of the crimp probe head 20, and the snap-fit portion 22 is disposed on the inner wall of the jack.

After the crimp probe head 20 is inserted into the jack, the snap-fit portion 22 is snap fitted into the snap-fit groove 122, which can implement axial limit for the base 12 and the crimp probe head 20 in an axial direction of the jack. This makes it more difficult for the crimp probe head 20 to be separated from the base 12 in the axial direction of the jack, thus reducing the risk of separation of the crimp probe head 20 from the base 12 in the axial direction of the jack during testing.

In some embodiments, the snap-fit groove 122 is a ring groove or the snap-fit groove 122 is a non-closed structure in a circumferential direction of the jack.

The ring groove is a closed structure formed by the snap-fit groove 122 extending around the axis of the jack. In some other embodiments, the snap-fit groove 122 is a non-closed structure in a circumferential direction of the jack. In other words, the snap-fit groove 122 may not be a ring groove, for example, the snap-fit groove 122 has a central angle of 30°, 60°, 120°, or the like.

If the snap-fit groove 122 is a ring groove, the snap-fit portion 22 can be snap fitted into the snap-fit groove 122 from any position in the circumferential direction of the snap-fit groove 122 without alignment or positioning, thereby reducing the difficulty of snap-fit. If the snap-fit groove 122 is a non-closed structure in a circumferential direction of the jack, the influence of provision of the snap-fit groove 122 on the structural strength of the base 12 or crimp probe head 20 provided with the snap-fit groove 122 can be reduced.

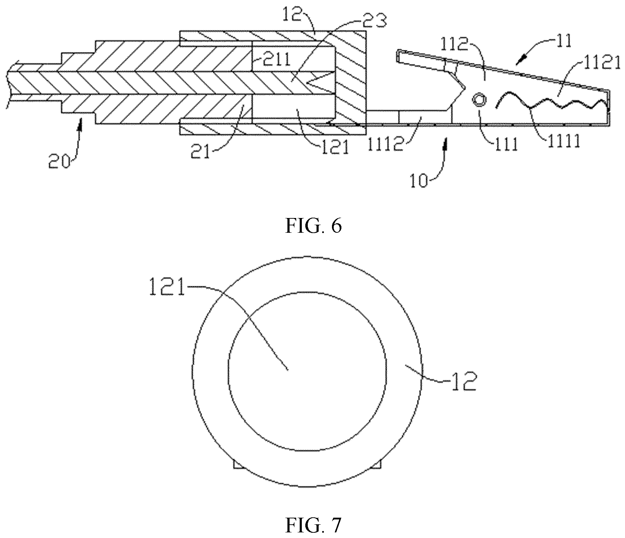

To improve the stability of the insertion fit between the crimp probe head 20 and the base 12, refer to FIG. 5 and FIG. 6. FIG. 5 is a cross-sectional view of a test clip 10 according to some other embodiments of this application, and FIG. 6 is a schematic diagram of the test clip 10 in FIG. 5 detachably connected to the crimp probe head 20. In some embodiments not encompassed by the wording of the claims, the jack is a threaded hole.

In an embodiment not encompassed by the wording of the claims, in which the jack is provided in the base 12, the jack is a threaded hole, and the second inserting portion 21 of the crimp probe head 20 is provided with an external thread that matches an internal thread of the threaded hole.

In an embodiments not encompassed by the wording of the claims, in which the jack is provided in the crimp probe head 20, the jack is a threaded hole, and the first inserting portion 121 of the base 12 is provided with an external thread that matches an internal thread of the threaded hole.

The jack being a threaded hole facilitates the connection between the base 12 and the crimp probe head 20. An axial limit can be formed between the crimp probe head 20 and the base 12 through threaded connection, leading to more stable connection between the crimp probe head 20 and the base 12.

In some embodiments, the crimp probe head 20 includes a second inserting portion 21 and a probe 23. The second inserting portion 21 is configured to fit with the jack in an insertion manner. The second inserting portion 21 has an insertion end 211 to be inserted into the jack. The probe 23 partially protrudes from the insertion end 211. The jack has a bottom wall. The bottom wall is used to abut against a part of the probe 23 protruding from the insertion end 211 after the second inserting portion 21 is inserted into the jack, so as to achieve an electrical connection between the probe 23 and the clip body 11.

The second inserting portion 21 is an insulator, and the probe 23 is a conductor. The second inserting portion 21 fits around the probe 23. The insertion end 211 of the second inserting portion 21 is an end face of the second inserting portion 21 entering the jack first in the process of the second inserting portion 21 being inserted into the jack. The probe 23 partially protrudes from the insertion end 211 so that the probe 23 enters the jack earlier than the insertion end 211 of the second inserting portion 21 in the process of the crimp probe head being inserted into the jack. After the second inserting portion 21 is inserted into the jack, one end, farther away from the inserting portion, of the part of the probe 23 protruding from the insertion end 211 can abut against the bottom wall of the jack, so as to achieve the electrical connection between the probe 23 and the base 12, thereby achieving the electrical connection between the crimp probe head 20 and the test clip 10.

In some other embodiments, the jack may alternatively run through two ends of the base 12 in the axial direction of the jack. In such embodiments, to achieve an electrical connection between the crimp probe head 20 and the test clip 10, it may be that the part of the probe 23 protruding from the insertion end 211 may abut against a side wall of the jack, or may extend out of the jack to abut against the clip body 11.

The jack has a bottom wall, meaning that the jack is a blind hole. The bottom wall of the jack is used to abut against the probe 23 to facilitate the electrical connection between the crimp probe head 20 and the test clip 10.

As shown in FIG. 7 which is a schematic diagram of a relative position relationship between the base 12 and the first inserting portion 121 of the test clip 10 according to some embodiments of this application, in some embodiments, the base 12 is cylindrical, and the base 12 is coaxial with the jack.

In an embodiment in which the jack is provided in the base 12, the base 12 is coaxial with the jack. In some other embodiments, the base 12 may alternatively be in other structural forms such as trigonal and quadrilateral. Certainly, the jack and the base 12 may alternatively be noncoaxial.

If the base 12 is cylindrical, the outer circumference of the base 12 is a cylindrical surface without ridges, which can reduce the risk of damage caused by bumping. The base 12 is coaxial with the jack, which allows a more regular structure of the test clip 10, facilitating a detachable connection between the crimp probe head 20 and test clip 10.

As shown in FIG. 2 and FIG. 5, in some embodiments, the clip body 11 is connected to one end of the base 12, and the jack is provided at the other end of the base 12 and recessed toward a direction approaching the clip body 11.

The end provided with the jack and the end connected to the clip body 11 are opposite ends of the base 12. For example, the jack and the clip body 11 are provided at two ends of an axial direction of the base 12. In some other embodiments, the jack and the clip body 11 may alternatively be arranged relative to the base 12 in other manners.

The jack and the clip body 11 are respectively provided at opposite ends of the base 12, facilitating installation of the crimp probe head 20 and the clip body 11 and reducing the risk of interference between the crimp probe head 20 and the clip body 11.

Still referring to FIG. 6, in some embodiments, the clip body 11 includes a first clamping portion 111 and a second clamping portion 112. The first clamping portion 111 is hinged to the second clamping portion 112. The first clamping portion 111 and the second clamping portion 112 are configured to cooperate to clamp a piece under test. The base 12 is connected to one end of the first clamping portion 111 or one end of the second clamping portion 112.

For example, the base 12 is connected to one end of the first clamping portion 111, the first clamping portion 111 includes two opposite connecting portions 1112 spaced apart, and the first clamping portion 111 is connected to the base 12 via the two connecting portions 1112.

A surface of the first clamping portion 111 facing toward the second clamping portion 112 is a first corrugated surface 1111, and a surface of the second clamping portion 112 facing toward the first clamping portion 111 is a second corrugated surface 1121 matching the first corrugated surface 1111. The first corrugated surface 1111 and the second corrugated surface 1121 can increase friction between the piece under test and the first clamping portion 111 and second clamping portion 112, thereby improving the clamping stability. The first clamping portion 111 is hinged to the second clamping portion 112, so rotation of the first clamping portion 111 relative to the second clamping portion 112 can cause the first corrugated surface 1111 to approach or leave the second corrugated surface 1121, allowing the first clamping portion 111 and the second clamping portion 112 to cooperate to clamp the piece under test.

The base 12 is connected to one end of the first clamping portion 111 or one end of the second clamping portion 112, allowing the other clamping portion to rotate relative to the clamping portion connected to the base 12, so that the two clamping portions cooperate to clamp the piece under test.

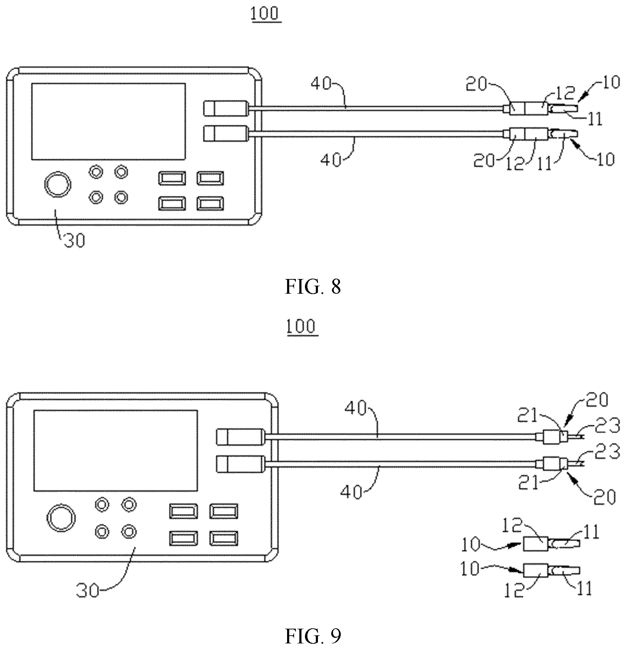

Referring to FIG. 8, FIG. 8 is a schematic diagram of a testing assembly 100 with test clips 10 and crimp probe heads 20 detachably connected to each other according to some embodiments of this application. An embodiment of this application provides a testing assembly 100. The testing assembly 100 includes the test clip 10 provided in any of the foregoing embodiments, a tester 30, and a crimp probe head 20. The crimp probe head 20 is electrically connected to the tester 30, and the crimp probe head 20 is configured to be detachably connected to a base 12 to achieve an electrical connection between the crimp probe head 20 and a clip body 11.

The tester 30 can display testing results such as measured voltage and/or current values of a battery. The crimp probe head 20 is electrically connected to the tester 30 via a wire 40. Two crimp probe heads 20 are provided. Each crimp probe head 20 is electrically connected to the tester 30 via a wire 40. Two test clips 10 are provided. The test clips 10 and the crimp probe heads 20 are arranged in one-to-one correspondence. As shown in FIG. 8, after the test clips 10 and the crimp probe heads 20 are connected, in testing a battery, one test clip 10 clamps a positive electrode terminal of the battery, and the other test clip 10 clamps a negative electrode terminal of the battery. As shown in FIG. 9, after the test clips 10 are separated from the crimp probe heads 20, in testing a battery, one crimp probe head 20 is in contact with a positive electrode terminal of the battery, and the other crimp probe head 20 is in contact with a negative electrode terminal of the battery.

In an embodiment not encompassed by the wording of the claims, in which the first inserting portion 121 of the test clip 10 is a threaded hole, the second inserting portion 21 of the crimp probe head 20 is provided with an external thread matching an internal thread of the threaded hole.

In an embodiments encompassed by the wording of the claims, in which the first inserting portion 121 of the test clip 10 is a jack, the jack is provided with a snap-fit groove 122 in the inner wall, and the second inserting portion 21 of the crimp probe head 20 is provided with a snap-fit portion 22 that is in snap fit with the snap-fit groove 122.

The testing assembly 100 includes the crimp probe head 20 and the test clip 10, and the crimp probe head 20 is electrically connected to the tester 30, so that the testing assembly 100 can directly test a piece under test using the crimp probe head 20. Alternatively, the base 12 of the test clip 10 may be detachably connected to the crimp probe head 20 to achieve an electrical connection between the clip body 11 and the crimp probe head 20, and then the test clip 10 can clamp the piece under test for testing. In this way, the testing assembly 100 can not only be used in testing environments that require a crimp-type probe head, but also be used in testing environments that require a clamp-type probe head, expanding the application range of the testing assembly 100.

An embodiment of this application provides a testing assembly 100 including a test clip 10 encompassed by the wording of the claims, a tester 30, and a crimp probe head 20. The crimp probe head 20 is electrically connected to the tester 30 via a wire 40. The test clip 10 includes a clip body 11 and a base 12. The clip body 11 is configured to clamp a piece under test. The base 12 is cylindrical, the base 12 is provided with a jack, and the jack is used for insertion fit with the crimp probe head to achieve a detachable connection between the crimp probe head 20 and the base 12. The jack is provided with a snap-fit groove 122 in the inner wall. The jack is provided with a snap-fit groove 122 in the inner wall, the crimp probe head 20 is provided with a snap-fit portion 22 that is in snap fit with the snap-fit groove 122. If the test clip 10 is not connected to the crimp probe head 20, the testing assembly 100 can directly test a piece under test using the crimp probe head 20. If the test clip 10 is connected to the crimp probe head 20, the clip body 11 and the crimp probe head 20 are electrically connected, and the test clip 10 can clamp the piece under test for testing. In this way, the testing assembly 100 can not only be used in testing environments that require a crimp-type probe head, but also be used in testing environments that require a clamp-type probe head, expanding the application range of the testing assembly 100.

The foregoing descriptions are merely preferred embodiments of this application which are not intended to limit this application. Persons skilled in the art understand that this application may have various modifications and variations.

## Claims

1. A test clip (10), comprising:
a clip body (11); and
a base (12) connected to the clip body (11), wherein the base (12) is configured to be detachably connected to a crimp probe head (20) to achieve an electrical connection between the crimp probe head (20) and the clip body (11);
wherein the base (12) has a first inserting portion (121), and the first inserting portion (121) is configured to fit with the crimp probe head (20) in an insertion manner;
wherein the first inserting portion (121) is a jack;
**characterized in that**
one of an inner wall of the jack and the crimp probe head (20) is provided with a snap-fit portion (22), and the other is provided with a snap-fit groove (122); wherein
the snap-fit portion (22) is configured to be snap fitted into the snap-fit groove (122) after the crimp probe head (20) is inserted into the jack; and
in an axial direction of the jack, the snap-fit portion (22) has a first guide slope (221) and a second guide slope (222) opposite each other, the first guide slope (221) is configured to guide the snap-fit portion (22) to be snap fitted into the snap-fit groove (122), and the second guide slope (222) is configured to guide the snap-fit portion (22) to be disengaged from the snap-fit groove (122).

2. The test clip (10) according to claim 1, wherein the snap-fit groove (122) is a ring groove or the snap-fit groove (122) is a non-closed structure in a circumferential direction of the jack.

3. The test clip (10) according to any one of claims 1 to 2, wherein the crimp probe head (20) comprises a second inserting portion (21) and a probe (23), wherein the second inserting portion (21) is configured to fit with the jack in an insertion manner, the second inserting portion (21) has an insertion end (211) to be inserted into the jack, and the probe (23) partially protrudes from the insertion end (211); and
the jack has a bottom wall, and the bottom wall is used to abut against a part of the probe (23) protruding from the insertion end (211) after the second inserting portion (21) is inserted into the jack, so as to achieve an electrical connection between the probe (23) and the clip body (11).

4. The test clip (10) according to any one of claims 1 to 3, wherein the base (12) is cylindrical, and the base (12) is coaxial with the jack.

5. The test clip (10) according to any one of claims 1 to 3, wherein the clip body (11) is connected to one end of the base (12), and the jack is provided at the other end of the base (12) and recessed toward a direction approaching the clip body (11).

6. The test clip (10) according to any one of claims 1 to 5, wherein the clip body (11) comprises a first clamping portion (111) and a second clamping portion (112), wherein the first clamping portion (111) is hinged to the second clamping portion (112), the first clamping portion (111) and the second clamping portion (112) are configured to cooperate to clamp a piece under test, and the base (12) is connected to one end of the first clamping portion (111) or one end of the second clamping portion (112).

7. A testing assembly (100), comprising:
the test clip (10) according to any one of claims 1 to 6;
a tester (30); and
a crimp probe head (20) electrically connected to the tester (30), wherein the crimp probe head (20) is configured to be detachably connected to the base (12) to achieve an electrical connection between the crimp probe head (20) and the clip body (11).

## Patentansprüche

1. Prüfklammer (10), aufweisend:
einen Klammerkörper (11); und
eine Basis (12), die mit dem Klammerkörper (11) verbunden ist, wobei die Basis (12) dazu eingerichtet ist, lösbar mit einem Quetschstecker (20) verbunden zu sein, um eine elektrische Verbindung zwischen dem Quetschstecker (20) und dem Klammerkörper (11) zu erzielen;
wobei die Basis (12) einen ersten Einführabschnitt (121) aufweist und der erste Einführabschnitt (121) dazu eingerichtet ist, einführend mit dem Quetschstecker (20) zusammenzupassen;
wobei der erste Einführabschnitt (121) eine Buchse ist;
**gekennzeichnet dadurch, dass** eines aus einer inneren Wand der Buchse und dem Quetschstecker (20) mit einem Einrastabschnitt (22) versehen ist und das andere daraus mit einer Einrastnut (122) versehen ist; wobei
der Einrastabschnitt (22) dazu eingerichtet ist, nachdem der Quetschstecker (20) in die Buchse eingeführt wurde, in die Einrastnut (122) eingerastet zu sein; und
der Einrastabschnitt (22) in axialer Richtung der Buchse eine erste Führungsschräge (221) und eine zweite Führungsschräge (222), die einander gegenüberliegen, aufweist, wobei die erste Führungsschräge (221) dazu eingerichtet ist, den Einrastabschnitt (22) dazu zu führen, in die Einrastnut (122) einzurasten, und die zweite Führungsschräge (222) dazu eingerichtet ist, den Einrastabschnitt (22) dazu zu führen, sich aus der Einrastnut (122) zu lösen.

2. Prüfklammer (10) nach Anspruch 1, wobei die Einrastnut (122) eine Ringnut ist oder die Einrastnut (122) eine nicht geschlossene Struktur in einer Umfangsrichtung der Buchse ist.

3. Prüfklammer (10) nach einem der Ansprüche 1 bis 2, wobei der Quetschstecker (20) einen zweiten Einführabschnitt (21) und eine Kontaktspitze (23) aufweist, wobei der zweite Einführabschnitt (21) dazu eingerichtet ist, einführend mit der Buchse zusammenzupassen, der zweite Einführabschnitt (21) ein in die Buchse einzuführendes Einführende (211) aufweist und die Kontaktspitze (23) teilweise aus dem Einführende (211) herausragt; und
die Buchse eine Bodenwand aufweist und die Bodenwand dazu verwendet wird, an einem Teil der Kontaktspitze (23) anzuliegen, der aus dem Einführende (211) herausragt, nachdem der zweite Einführabschnitt (21) in die Buchse eingefügt wurde, um eine elektrische Verbindung zwischen der Kontaktspitze (23) und dem Klammerkörper (11) zu erzielen.

4. Prüfklammer (10) nach einem der Ansprüche 1 bis 3, wobei die Basis (12) zylindrisch ist und die Basis (12) koaxial zu der Buchse ist.

5. Prüfklammer (10) nach einem der Ansprüche 1 bis 3, wobei der Klammerkörper (11) mit einem Ende der Basis (12) verbunden ist und die Buchse an dem anderen Ende der Basis (12) bereitgestellt und in Richtung auf den Klammerkörper (11) vertieft ist.

6. Prüfklammer (10) nach einem der Ansprüche 1 bis 5, wobei der Klammerkörper (11) einen ersten Klemmabschnitt (111) und einen zweiten Klemmabschnitt (112) aufweist, wobei der erste Klemmabschnitt (111) an den zweiten Klemmabschnitt (112) scharniert ist, der erste Klemmabschnitt (111) und der zweite Klemmabschnitt (112) dazu eingerichtet sind, ein Stück zu klemmen, das einer Prüfung unterzogen wird, und die Basis (12) mit einem Ende des ersten Klemmabschnitts (111) oder einem Ende des zweiten Klemmabschnitts (112) verbunden ist.

7. Prüfanordnung (100), aufweisend:
die Prüfklammer (10) nach einem der Ansprüche 1 bis 6;
ein Prüfgerät (30); und
einen Quetschstecker (20), der elektrisch mit dem Prüfgerät (30) verbunden ist, wobei der Quetschstecker (20) dazu eingerichtet ist, lösbar mit der Basis (12) verbunden zu sein, um eine elektrische Verbindung zwischen dem Quetschstecker (20) und dem Klammerkörper (11) zu erzielen.

## Revendications

1. Pince de test (10), comprenant:
un corps de pince (11); et
une base (12) connectée au corps de pince (11), dans laquelle la base (12) est configurée pour être connectée de manière amovible à une tête de sonde de sertissage (20) pour réaliser une connexion électrique entre la tête de sonde de sertissage (20) et le corps de pince (11);
dans laquelle la base (12) comporte une première partie d'insertion (121), et la première partie d'insertion (121) est configurée pour s'adapter à la tête de sonde de sertissage (20) de manière à être insérée;
dans laquelle la première partie d'insertion (121) est un prise;
**caractérisé en ce qu'**une paroi interne de la prise et de la tête de sonde de sertissage (20) est pourvue d'une partie d'encliquetage (22), et l'autre est pourvue d'une rainure d'encliquetage (122); dans laquelle
la partie d'encliquetage (22) est configurée pour être encliquetée dans la rainure d'encliquetage (122) après que la tête de sonde de sertissage (20) est insérée dans la prise; et
dans une direction axiale de la prise, la partie d'encliquetage (22) comporte une première pente de guidage (221) et une deuxième pente de guidage (222) opposées l'une à l'autre, la première pente de guidage (221) est configurée pour guider la partie d'encliquetage (22) afin qu'elle soit encliquetée dans la rainure d'encliquetage (122), et la deuxième pente de guidage (222) est configurée pour guider la partie d'encliquetage (22) afin qu'elle soit désengagée de la rainure d'encliquetage (122).

2. Pince de test (10) selon la revendication 1, dans lequel la rainure d'encliquetage (122) est une rainure annulaire ou la rainure d'encliquetage (122) est une structure non fermée dans une direction circonférentielle de la prise.

3. Pince de test (10) selon l'une quelconque des revendications 1 à 2, dans laquelle la tête de sonde de sertissage (20) comprend une deuxième partie d'insertion (21) et une sonde (23), dans laquelle la deuxième partie d'insertion (21) est configurée pour s'adapter à la prise de manière à être insérée, la deuxième partie d'insertion (21) comporte une extrémité d'insertion (211) à être insérée dans la prise, et la sonde (23) dépasse partiellement de l'extrémité d'insertion (211); et
la prise comporte une paroi inférieure, et la paroi inférieure est utilisée pour s'appuyer contre une partie de la sonde (23) dépassant de l'extrémité d'insertion (211) après que la deuxième partie d'insertion (21) est insérée dans la prise, de manière à réaliser une connexion électrique entre la sonde (23) et le corps de pince (11).

4. Pince de test (10) selon l'une quelconque des revendications 1 à 3, dans laquelle la base (12) est cylindrique, et la base (12) est coaxiale avec la prise.

5. Pince de test (10) selon l'une quelconque des revendications 1 à 3 dans laquelle le corps de pince (11) est connecté à une extrémité de la base (12), et la prise est fournie à l'autre extrémité de la base (12) et en retrait vers une direction approchant le corps de pince (11).

6. Pince de test (10) selon l'une quelconque des revendications 1 à 5, dans laquelle le corps de pince (11) comprend une première partie de serrage (111) et une deuxième partie de serrage (112), dans laquelle la première partie de serrage (111) est articulée à la deuxième partie de serrage (112), la première partie de serrage (111) et la deuxième partie de serrage (112) sont configurées pour coopérer afin de serrer une pièce à tester, et la base (12) est connectée à une extrémité de la première partie de serrage (111) ou à une extrémité de la deuxième partie de serrage (112).

7. Ensemble de test (100), comprenant:
le pince de test (10) selon l'une quelconque des revendications 1 à 6;
un testeur (30); et
une tête de sonde de sertissage (20) connectée électriquement au testeur (30), dans lequel la tête de sonde de sertissage (20) est configurée pour être connectée de manière amovible à la base (12) afin de réaliser une connexion électrique entre la tête de sonde de sertissage (20) et le corps de pince (11).
